Europäisches Patentamt

European Patent Office

Office européen des brevets

(11) Publication number: **0 064 854**
**B1**

(12) **EUROPEAN PATENT SPECIFICATION**

(45) Date of publication of patent specification: **06.02.85**

(21) Application number: **82302263.7**

(22) Date of filing: **04.05.82**

(51) Int. Cl.⁴: **H 01 L 23/14**

(54) Component assembly including a rigid substrate.

(30) Priority: **06.05.81 GB 8113873**

(43) Date of publication of application:
**17.11.82 Bulletin 82/46**

(45) Publication of the grant of the patent:
**06.02.85 Bulletin 85/06**

(84) Designated Contracting States:
**AT BE CH DE FR IT LI NL SE**

(56) References cited:
**EP-A-0 013 562**
**GB-A-1 419 163**
**US-A-3 780 352**
**US-A-3 896 544**

(73) Proprietor: **ITT INDUSTRIES INC.**
**320 Park Avenue**
**New York, NY 10022 (US)**
㊄ **BE CH FR IT LI NL SE AT**

(73) Proprietor: **Deutsche ITT Industries GmbH**
**Hans-Bunte-Strasse 19 Postfach 840**
**D-7800 Freiburg (DE)**
㊄ **DE**

(72) Inventor: **El Refaie, Mohamed Mah Abdalla**
**17 Ladhope Drive**
**Ladhope Galashiels TD1 2BL Scotland (GB)**

(74) Representative: **Dennis, Mark Charles et al**
**STC Patent Department Edinburgh Way**
**Harlow Essex CM20 2SH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to interconnection substrates for surface mounting of circuit elements in the form of unpackaged (bare) integrated circuit chips for autowire bonding, of chips carried on tape for tape automated bonding, and of packaged chips in ceramic or plastics leadless chipcarriers, all of which are hereinafter referred to as 'components'.

It is known that in electronic systems increased systems performance, as indicated by reduced circuit and system delay times, is achievable by the use of increased integration at the chip level. It is also known that the increase in level of integration is associated with the increase in the signal pin out requirement. The dominant form of chip packaging at present is the dual in line package configuration where the signal pin outs are formed such that they can be inserted into component mounting holes in the well known plated-through-hole printed circuit boards. This packaging configuration imposes severe limitations on systems performance due to both the penalty imposed on the area available for interconnection on the substrate and the electrical performance of circuitry. The development of large and very large scale integration (LSI and VLSI) and very high speed integrated circuits (VHSIC) in turn require an increasing number of signal pin outs, hence the present trend towards advanced techniques of chip packaging and attachment on the surface of the interconnection substrate.

Single and multilayer thick film hybrid ceramic substrate for interconnection between components in the forms of bare chips and for surface attachment of leadless ceramic chip carriers are already in use due to the apparent advantage of the match of the thermal coefficient of expansion of silicon and alumina (which will be detailed later). Ceramic substrates, however, suffer from some disadvantages such as high dielectric constant, limited area for interconnection, limited conductor width and spacing (dictated by accuracies achievable with screen printing techniques), and high costs of some of the materials used, e.g. gold, in conductor inks.

Consider the stresses at the junction between the components and the substrate due to differential thermal levels are due to the forces F expressed by:

$$F \propto A \times (\alpha_c - \alpha_s) \times \frac{Es}{Es/Ec+1} \times \Delta T$$

where

A is the cross sectional area of the junctions

$\alpha_c$ coefficient of thermal expansion of component

$\alpha_s$ coefficient of thermal expansion of substrate

$\Delta T$ temperature differential

Es Elastic modulus of substrate

Ec Elastic modulus of component and

$$E = \frac{Es}{Es/Ec+1} \qquad E \to 0 \text{ as } Es \to 0$$

This term also appears in other stress functions for mechanical or other loading conditions. Therefore the following applies.

For a finite temperature differential between component and substrate and for a finite junction area, the forces at the junction may be rendered very small when either or both the following conditions is satisfied.

$$\alpha_c \to \alpha_s \qquad (1)$$

$$E_s \to 0 \qquad (2)$$

Condition (1) may be satisfied by using materials with matched thermal expansion which is the case with thick film hybrid ceramic substrates as outlined above.

Condition (2) may be satisfied when using a substrate with very low elastic modulus.

Another source of stress between directly mounted components and the printed circuits upon which the components are mounted is flexure of the printed circuit substrate due to external loads. This is particularly relevant where the substrate is made from materials such as paper based laminated sheet bonded with epoxy resins. One way of eliminating the disadvantages accruing from the direct mounting of leadless components on flexible printed circuit substrates is disclosed in British patent specification No. 1,565,748, which teaches special shaping and reduction in area of the solderable contact areas to which the components are soldered.

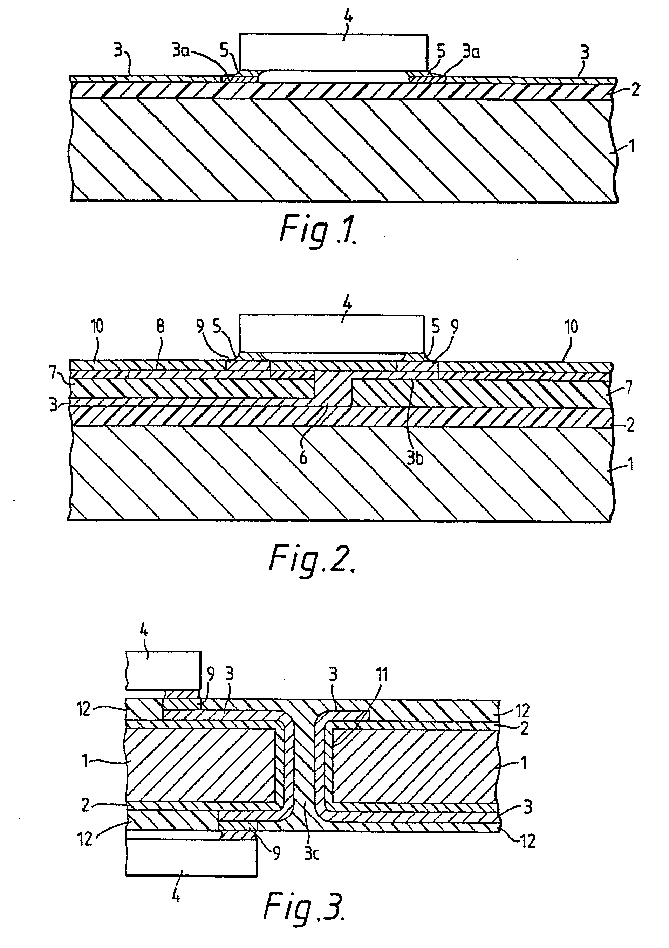

According to the present invention there is provided a component assembly comprising a rigid substrate base supporting a conductor pattern over at least one face thereof to which conductor pattern components are attached by electrical interconnections between the components and the pattern, characterised in that between the conductor pattern (3, Figure 1) and the rigid substrate base (1, Figure 1) there is provided an intermediate layer of compliant insulating material (2, Figure 1) on the at least one face.

The invention also provides an electrical circuit board comprising a rigid substrate base carrying a conductor pattern on a side thereof, the pattern being designed to receive surface mounted components connected directly to the pattern, characterised in that the board has a compliant insulating intermediate layer (2, Figure 1) between the base (1, Figure 1) and the conductor pattern (3, Figure 1), the intermediate layer being such as to absorb differential thermal expansions which may occur between the components, when mounted, and the base.

Embodiments of the invention will now be described with reference to the accompanying drawings, in which:

Figure 1 shows a method of mounting a component on a compliant substrate;

Figure 2 shows an alternative construction for a compliant substrate, and

Figure 3 shows a construction for a double sided compliant substrate.

In the method shown in Figure 1 a substrate base 1 of a suitable rigid material (either insulating or conducting) has deposited on its surface a thin layer 2 of insulating elastomer with a low elastic modulus. The rigid base may be a metal, e.g., copper, aluminium, to promote good thermal conduction or an insulator such as a ceramic, glass reinforced plastic, epoxy, polyimide or PTFE. Conventional surface treatment of the base may be undertaken to improve the adhesion thereto of the elastomer layer. The elastomer layer 2 is then applied by dipping, spraying, laminating, curtain coating, or otherwise coating the surface of the base. The elastomer layer 2 is preferably an uncured thermosetting polymer which when subsequently cured has suitable properties to accept the subsequently deposited metal conductor pattern. Polymers with known electrical properties and application comprise epoxy resins, polyimides, acrylonitrile butadienes etc. The applied polymer is then heat cured to the thermoset state, e.g. 160°—250°C for 1—3 hours depending on the type of polymer. The surface of the cured polymer is then prepared in a conventional manner for the subsequent electroless deposition of metal, e.g. copper. A metal conductor pattern 3 is then electroless deposited on the prepared surface, the pattern comprising conductors terminating in pads or lands 3a where electrical interconnections are to be made with a superposed component. The electroless metal pattern is then electroplated to form the final conductor pattern. The component 4, which is formed with appropriate metallic contact areas, is then placed in position on the conductor pattern and interface junctions 5 are formed by soldering. Because of the compliance of the elastomer layer strain due to thermal expansion mismatch is not transmitted to the solder joints. It is obvious that the rigid base may be processed to provide for component mounting on both sides of the substrate.

Where more complicated interconnection arrangements are required, e.g. between a multiplicity of components mounted on a common substrate, it may be necessary to provide two or more interconnection layers on the same side of the substrate. Such an arrangement is shown in Figure 2. The substrate 1 is first coated with a first thin elastomer layer 2 upon which the first conductor pattern 3 is formed, as previously described.

Vertical interconnects or "vias" 6 are then formed by, e.g. well-known pillar plating techniques. A second elastomer layer 7 is then deposited, leaving the tops of the vias exposed. Additional metal deposition is then effected to provide a second conductor pattern 8 insulated from the first pattern. At the same time additional conductor patterns 3b. may be formed which are extensions of the initial conductor pattern 3, being electrically connected thereto by the vias 6. Contact areas 9 are then formed and finally a thin elastomer layer 10 is applied overall leaving the contact areas 9 exposed for mounting the components in the manner previously described.

When two interconnection layers are required on either side of the substrate a construction such as that shown in Figure 3 may be used. If the rigid base 1 is made of a conducting material, e.g. copper or aluminium, via holes 11 are initially punched or drilled and the first thin elastomer layer 2 is applied in such a manner as to coat the inside of the holes 11 as well as the flat surfaces of the base. The conductor patterns 3 are then formed, with parts of the pattern 3c forming plated through hole vias using the steps outlined above. Contact areas 9 are provided as before and the substrate is completed by applying a final elastomer coating 12.

For rigid bases made of an insulating material the initial layers of elastomer can be applied and cured before forming the via holes and the subsequent deposition of the metallic patterns. When more than two layers are required additional layers can be provided on one or both sides of the substrate using the steps outlined with reference to Figure 2.

As an alternative to electroless deposition of metallic conductors it is possible to form patterns of conductive polymers which may be suitable in themselves without further metallisation or which may then be electroplated with metal. Where electroless plating is to be used several methods of achieving the conductor pattern are possible. The elastomer layer may be selectively treated to accept the electroless deposition and subsequent electroplating in a purely additive process. Alternatively the entire elastomer surface may be treated and electrolessly coated, following which a photoresist coating is applied, selectively exposed and processed to receive the electroplating, after which the unexposed photoresist and the underlying and unwanted electroless metal areas are removed. Yet again it is possible to incorporate a metal salt detector, e.g. copper salt detector, in the elastomer which, when selectively exposed to ultra violet radiation make a receptor for electroless deposition.

It will be appreciated that the thickness of the elastomer layer depends on the requirements of the finished product. The thicker the layer the more stress relief there will be between the component and the rigid substrate. Conversely the thinner the layer the better will be heat dissipation from the components via the substrate, particularly if the latter has a rigid metal base.

## Claims

1. A component assembly comprising a rigid substrate base supporting a conductor pattern over at least one face thereof to which conductor pattern components are attached by electrical interconnections between the components and the pattern, characterised in that between the conductor pattern (3, Figure 1) and the rigid substrate base (1, Figure 1) there is provided an intermediate layer of compliant insulating material (2, Figure 1) on the at least one face.

2. An assembly according to Claim 1, characterised in that on each face of the base (1, Figure 3) a compliant layer (2, Figure 3) is provided, the surface of each compliant layer remote from the base carrying a pattern of metallic conductors (3, Figure 3) to which components (4, Figure 3) are attached by electrical connections between the components and the conductor patterns, the assembly including one or more holes (11, Figure 3) through the base, said holes containing metallic interconnections between the metallic conductor patterns on the two faces of the substrate.

3. An assembly according to Claim 1 or 2 characterised in that the assembly includes on the or each face an additional layer(s) of compliant insulating material (7, Figure 2) and metallic conductor pattern(s) (8, Figure 2) between the surface layer and the first mentioned compliant layer, the additional conductor layer(s) being connected to the surface conductor layer by vertical metallic interconnections (6, Figure 2) formed through the intervening layer(s) of compliant material.

4. An assembly according to any one of Claims 1—3 characterised in that the compliant material is a thermosetting elastomer.

5. An assembly according to any preceding claim characterised in that the conductor patterns comprise an initial pattern of electroless deposited metal and a final conductor pattern of electroplated metal.

6. An assembly according to any one of Claims 1—5 characterised in that the rigid substrate base is made of an insulating material.

7. An assembly according to Claim 6 characterised in that the base is made of alumina ceramic, glass reinforced epoxy, polyimide or PTFE.

8. An assembly according to any one of Claims 1—5 characterised in that the rigid substrate base is made of metal.

9. An electrical circuit board comprising a rigid substrate base carrying a conductor pattern on a side thereof, the pattern being designed to receive surface mounted components connected directly to the pattern, characterised in that the board has a compliant insulating intermediate layer (2, Figure 1) between the base (1, Figure 1) and the conductor pattern (3, Figure 1), the intermediate layer being such as to absorb differential thermal expansions which may occur between the components, when mounted, and the base.

## Patentansprüche

1. Bauelementeanordnung mit einem starren Substrat, das wenigstens auf einer Seite Leiterstrukturen, an die durch elektrische Zwischenverbindungen Bauelemente angeschlossen sind, trägt, dadurch gekennzeichnet, daß zwischen der Leiterstruktur (3, Fig. 1) und dem starren Substrat (1, Fig. 1) wenigstens auf einer Seite eine nachgiebige Isolierschicht (2, Fig. 1) vorgesehen ist.

2. Bauelementeanordnung nach Anspruch 1, dadurch gekennzeichnet,

— daß auf jeder Seite des Substrats (1, Fig. 3) eine nachgiebige Schicht (2, Fig. 3) vorgesehen ist,
— daß die vom Substrat abgewandten Oberflächen der nachgiebigen Schichten eine metallische Leiterstruktur (3, Fig. 3), an die Bauelemente (4, Fig. 3) durch elektrische Zwischenverbindungen angeschlossen sind, tragen und
— daß die Bauelementeanordnung eine oder mehrere Öffnungen (11, Fig. 3) im Substrat hat, wobei sie metallische Verbindungselemente zwischen den metallischen Leiterstrukturen auf beiden Seiten des Substrats enthalten.

3. Bauelementeanordnung nach Anspruch 1 oder 2, dadurch gekennzeichnet,

— daß sie auf mindestens einer Seite eine zusätzliche nachgiebige Isolierschicht (7, Fig. 2) und eine zusätzliche Leiterschicht (8, Fig. 2) trägt und
— daß die zusätzliche(n) Leiterschicht(en) (8, Fig. 2) mit der Leiterstruktur (3, Fig. 2) durch vertikale Metallbrücken (6, Fig. 2), die durch die zwischenliegende(n) Schicht(en) des nachgiebigen Materials hindurchgeführt ist (sind), verbunden ist (sind).

4. Bauelementeanordnung nach einem der Ansprüche 1 bis 3, dadurch gekennzeichnet, daß die nachgiebige Schicht ein thermohärtbares Elastomer ist.

5. Bauelementeanordnung nach einem der Ansprüche 1 bis 4, dadurch gekennzeichnet, daß die Leiterstruktur zunächst eine Struktur aus stromlos abgeschiedenem Metall und dann eine Struktur aus elektrolytisch abgeschiedenem Metall enthält.

6. Bauelementeanordnung nach einem der Ansprüche 1 bis 5, dadurch gekennzeichnet, daß das starre Substrat aus Isoliermaterial hergestellt ist.

7. Bauelementeanordnung nach Anspruch 6, dadurch gekennzeichnet, daß das Substrat aus Keramik, glasfaserverstärktem Epoxyharz, Polyimid oder Polytetrafluoräthylen besteht.

8. Bauelementeanordnung nach einem der Ansprüche 1 bis 5, dadurch gekennzeichnet, daß das Substrat aus Metall besteht.

9. Schaltungsplatine mit einem starren Substrat das auf einer Seite eine Leiterstruktur trägt, wobei die Leiterstruktur so ausgebildet ist, daß auf der Oberfläche montierte Bauelemente direkt mit der Leiterstruktur verbunden sind, dadurch gekennzeichnet, daß die Schaltungsplatine eine isolierende, nachgiebige Schicht (2, Fig. 1) zwischen der Trägerschicht (1, Fig. 1) und der Leiterstruktur (3, Fig. 1) besitzt und die nachgiebige Schicht die unterschiedlichen thermischen Ausdehnungen, die zwischen den montierten Bauelementen und dem starren Substrat auftreten, aufnimmt.

**Revendications**

1. Assemblage de composants comprenant une base rigide de substrat supportant une configuration de conducteurs appliquée sur au moins une face de ladite base, des composants étant mis en place sur ladite configuration de conducteurs par des interconnexions électriques entre les composants et la configuration, caractérisé en ce qu'une couche de matériau isolant souple (2, figure 1) est disposée entre la configuration (3, figure 1) et la base rigide du substrat (1, figure 1), sur une face au moins.

2. Assemblage de composants conforme à la revendication 1, caractérisé en ce qu'une couche souple (2, figure 3) est prévue sur chaque face de la base (1, figure 3), dont la surface éloignée de la base supporte des conducteurs métalliques (3, figure 3) sur lesquels des composants (4, figure 3) sont connectés par des connexions électriques prévues entre les composants et les conducteurs, l'assemblage comportant un ou plusieurs trous (11, figure 3) traversant la base, lesdits trous contenant des interconnexions métalliques entre les configurations de conducteurs sur les deux faces du substrat.

3. Assemblage conforme à la revendication 1 ou 2, caractérisé en ce qu'il comporte sur la ou les faces une ou plusieurs couches supplémentaires de matériau isolant souple (7, figure 2) et une ou plusieurs configurations de conducteurs (8, figure 2) entre la couche de surface et la première couche souple mentionnée, la ou les couches conductrices supplémentaires étant reliées à la couche conductrice de surface par des interconnexions métalliques verticales (6, figure 2) pratiquées à travers la ou les couches intermédiaires du matériau souple.

4. Assemblage conforme à l'une des revendications 1 à 3, caractérisé en ce que le matériau souple est un élastomère thermodurcissable.

5. Assemblage conforme à l'une quelconque des revendications précédentes, caractérisé en ce que les conducteurs comportent une première couche de matériau déposé par voie non galvanique et un conducteur définitif en métal déposé électrolytiquement.

6. Assemblage conforme à l'une quelconque des revendications 1 à 5, caractérisé en ce que la base rigide du substrat est réalisée en un matériau isolant.

7. Assemblage conforme à la revendication 6, caractérisé en ce que le socle est réalisé en céramique à base d'alumine, en résine époxyde renforcée de fibres de verre, en polyimide ou en PTFE.

8. Assemblage conforme à l'une quelconque des revendications 1 à 5, caractérisé en ce que la base rigide du substrat est réalisée en métal.

9. Plaquette de circuits électriques comprenant une base rigide de substrat, supportant une configuration de conducteurs sur l'une des faces de ladite base, cette configuration étant conçue pour recevoir des composants montés en surface et directement reliés aux conducteurs, caractérisé en ce que la plaquette comporte une couche intermédiaire isolante souple (2, figure 1) entre le socle (1, figure 1) et la configuration de conducteurs (3, figure 1), la couche intermédiaire étant réalisée pour absorber les dilatations thermiques différentielles susceptibles de survenir entre les composants, lorsqu'ils sont montés, et la base.

Fig .1.

Fig.2.

Fig.3.